# EUROPEAN PATENT APPLICATION

(11) **EP 1 978 564 A2**
(43) Date of publication of application: **08.10.2008**
(21) Application number: 08152963.8
(22) Date of filing: 19.03.2008
(51) Int. Cl.: H01L 31/05, H01L 31/042

(54) **Method and apparatus for soldering interconnectors to photovoltaic cells**

(30) Priority: 02.04.2007 JP 2007096530
(71) Applicant: Nisshinbo Industries, Inc., Nihonbashi Chuo-ku Tokyo 103-8650 (JP)
(72) Inventor: Katayama, Manabu, Okazaki Shi 444-8560 (JP); Ichimura, Hikaru, Okazaki Shi 444-8560 (JP)
(74) Representative: Jannig, Peter

(57) **Abstract**

A method and apparatus for soldering interconnectors to photovoltaic cells that, after soldering, prevents bending of the photovoltaic cells due to heat warping caused by heat contraction of the lead wires. The interconnectors are positioned at predetermined positions on the photovoltaic cell, the interconnectors and the photovoltaic cells are held tightly together, and the solder is melted as the photovoltaic cells are heated, after which the photovoltaic cells are sequentially cooled in the long direction of the interconnectors with cold blasts from the end of the photovoltaic cells in the long direction of the interconnector.

## Description

### CLAIM FOR PRIORITY

The present specification claims priority from Japanese Patent Application No. 2007-096530, filed on April 2, 2007 in the Japan Patent Office, the entire contents of which are hereby incorporated by reference herein.

### BACKGROUND

### FIELD OF THE INVENTION

The present invention relates to a method and an apparatus for soldering interconnectors onto photovoltaic cells (hereinafter also simply "cell" or "cells") that form a photovoltaic module in the manufacture of such photovoltaic module.

### DESCRIPTION OF THE BACKGROUND ART

Interconnectors that attach to photovoltaic cells are comprised of a copper lead wire and a solder coating that coats the lead wire.

Conventionally, when attaching the interconnectors to the photovoltaic cells, the interconnectors are pressed and supported against the cell by bar- or rod-shaped rigid press members and heated to melt the solder, after which the cells are cooled, thus soldering the interconnectors to the photovoltaic cells. In JP-H11-87756-A and JP-2003-168811-A, this type of technology is disclosed.

When soldering the interconnectors to the photovoltaic cells, cooling of the photovoltaic cells after heating is accomplished by removing the cells from the heat source (a heater or the like), blowing ambient-temperature air over the entire photovoltaic cell or all areas of the interconnectors, or removing the photovoltaic cells from a heating oven to cool under ambient temperature conditions.

With such cooling methods, the cell cools from the outer ends inward, with attachment of the interconnectors proceeding from both ends toward the center.

Under such conditions, once the interconnectors are attached to the ends of the photovoltaic cell, the interconnectors try to shrink further as the temperature continues to drop after they are soldered in place, generating a compressive force that causes the cell to bend.

In addition, when cooled gradually at room temperature, the solder that coats the copper lead wires hardens before the copper lead wires undergo adequate heat contraction, and a difference in thermal expansion coefficient between the lead wires and the cell sometimes causes the cell to bend.

With current photovoltaic cells, in which the photovoltaic cells themselves are formed very thin, bending and other deformations often occur. In a square cell approximately 150 mm long on each side, bend of approximately 6 to 10 mm can occur, and a bend of that extent can cause the cell to crack.

Further, when a bent or otherwise deformed photovoltaic cell is made part of a photovoltaic module, in the process of forming the photovoltaic module that deformation is mechanically corrected. Such mechanical correction places stress on the cell, causing the cell to crack, or to crack when conveyed to the next process.

The photovoltaic cells account for a very high proportion of the cost of photovoltaic devices, and therefore defects due to cracks not only lower productivity but also increase production costs.

Although a method for soldering is disclosed in JP-H11-87756-A and JP-2003-168811-A, no solution to the above-described problems is disclosed in either JP-H11-87756-A or JP-2003-168811-A.

### SUMMARY

The present invention has as its object to provide a soldering method and an apparatus that prevent bending of photovoltaic cells due to a difference in heat contraction between a lead wire and the cell after soldering interconnectors to the photovoltaic cells.

To achieve the above-described object, the present invention provides a method for soldering an interconnector to a photovoltaic cell, comprising positioning the interconnector at a predetermined position on the photovoltaic cell, holding the interconnector and the photovoltaic cell tightly together, melting the solder while heating the photovoltaic cell, and sequentially cooling the heated photovoltaic cell in a long direction of the interconnector with cold blasts from end of the photovoltaic cell in a long direction of the interconnector.

In addition, preferably, the cold blasts with which the photovoltaic cell is cooled are simultaneously supplied across an entire width of the photovoltaic cell in a direction at a right angle to the interconnector soldered to the photovoltaic cell and locally in the long direction of the interconnector.

Preferably, the cold blasts with which the photovoltaic cell is cooled are supplied from one or more nozzles.

Preferably, the cold blasts with which the photovoltaic cell is cooled are a cooling gas comprising any one of chlorofluorocarbon, nitrogen, carbon dioxide, and inert gases, or any combination thereof.

The above-described object of the present invention is also achieved by an apparatus for cooling a photovoltaic cell to which an interconnector is soldered, comprising a heating space to melt the solder while heating the photovoltaic cell to attach the interconnector to the cell, a transport conveyer to transport the photovoltaic cell to and from the heating space, and a plurality of supply ports. At least one supply port of the plurality of supply ports is disposed above an exit of the heating space and at least one other supply port of the plurality of supply ports is disposed below the exit of the heating space, with the plurality of supply ports sandwiching the photovoltaic cell on the transport conveyer therebetween to blow cold blasts to sequentially cool the heated photovoltaic cell in a long direction of the interconnector from end of the photovoltaic cell in a long direction of the interconnector. A tip portion of each supply port of the plurality of supply ports has a tapered section of reduced width in the long direction of the interconnector proximal to the transport conveyer.

The method and apparatus for soldering an interconnector to a photovoltaic cell of the present invention provide at least one of the following effects.
(1) Since the photovoltaic cell is cooled from the end inward, attachment of the solder is made to proceed from the cell end toward the other end, enabling interconnector compressive force after cooling to be reduced and as a result allowing soldering with little bending to be carried out.
(2) Since the photovoltaic cell is cooled from the end inward, when the lead wire inside the interconnector positioned at the attachment part undergoes heat contraction, it can move within solder that has not yet hardened. Accordingly, interconnector compressive force after cooling can be reduced, enabling soldering with little bending to be carried out.
(3) Since the photovoltaic cell is cooled from the end inward, the lead wire is made to undergo heat contraction before the solder hardens, thus enabling interconnector compressive force after cooling to be further reduced, enabling soldering with little bending to be carried out.
(4) With little bending, soldering with very low rates of cracking can be achieved even with thin cells.
(5) Since soldering with little bending can be achieved, rates of later-stage cracking are reduced.
(6) With little bending, stable suctional transport can be achieved.
(7) With little bending, there is little positional deviation in the spacing between cells during later-stage laminating, thus reducing the rate of occurrence of such defects as short-circuiting between cells and improving the external appearance (cell spacing is uniform).

Other features and advantages of the present invention will be apparent from the following description when taken in conjunction with the accompanying drawings, in which like reference characters designate similar or identical parts throughout the several views thereof.

### BRIEF DESCRIPTION OF THE DRAWINGS

FIG. 1 shows a plan view of photovoltaic cells to which interconnectors are to be soldered;
FIG. 2 shows a sectional view of the photovoltaic cells shown in FIG. 1;
FIG. 3 shows a lateral sectional view showing schematically steps in implementing a soldering method according to the present invention;
FIGS. 4A and 4B show perspective views of one example of a photovoltaic cell holder used in the soldering method according to the present invention;
FIG. 5 shows a first embodiment of a cooling unit 80 used in the soldering method according to the present invention;
FIG. 6 shows a second embodiment of a cooling unit 80 used in the soldering method according to the present invention;
FIG. 7 shows a third embodiment of a cooling unit used in the soldering method according to the present invention; and
FIGS. 8A and 8B show sectional views of a connecting portion between a photovoltaic cell and an interconnector.

### DETAILED DESCRIPTION

A detailed description will now be given of illustrative embodiments of the present invention, with reference to the accompanying drawings. In so doing, specific terminology is employed solely for the sake of clarity, and the present disclosure is not to be limited to the specific terminology so selected. It is to be understood that each specific element includes all technical equivalents that operate in a similar manner and achieve a similar result.

### The Photovoltaic Cell

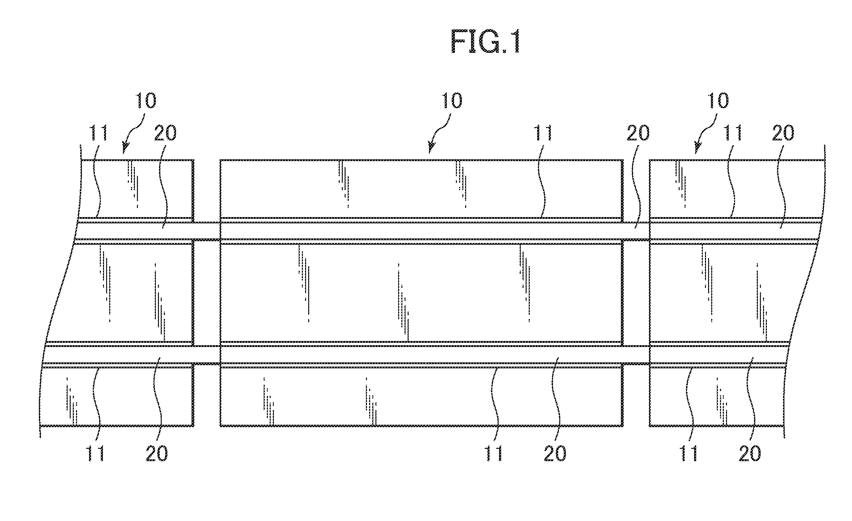

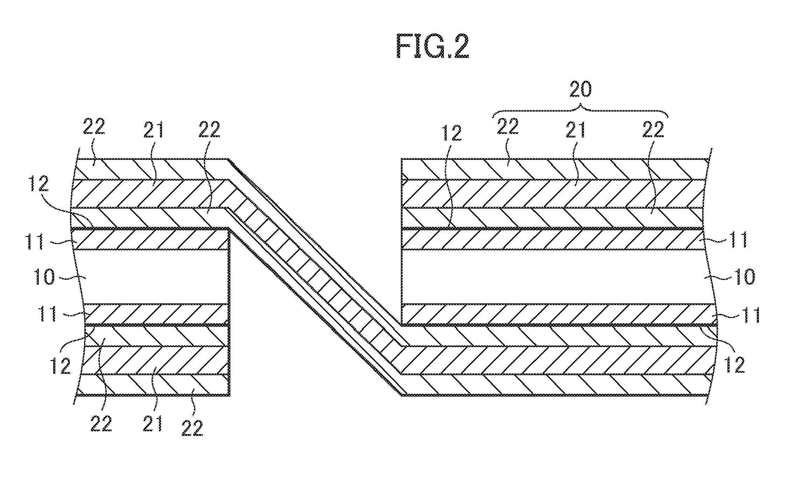

FIGS. 1 and 2 show photovoltaic cells 10 to which interconnectors 20 are to be soldered.

As shown in FIG. 1, two parallel rows of electrodes 11 are provided on the surfaces of the photovoltaic cell 10.

As shown in FIG. 2, positive electrodes 11 are provided on the top surface of the photovoltaic cell 10 and negative electrodes 11 are provided on the bottom surface of the photovoltaic cell 10. A plurality of photovoltaic cells 10 is aligned and the electrodes 11 on the top surfaces of adjacent photovoltaic cells 10 and the electrodes 11 on the bottom surfaces of adjacent photovoltaic cells 10 are connected in series by interconnectors 20.

Each interconnector 20 is comprised of a copper lead wire 21 and a solder coating 22 that coats the lead wire 21. An attachment portion 12 is formed by soldering at a part that contacts the photovoltaic cell 10, and through the attachment portion 12 the interconnector 20 is connected to the electrode 11 of the photovoltaic cell 10.

### The Soldering Method

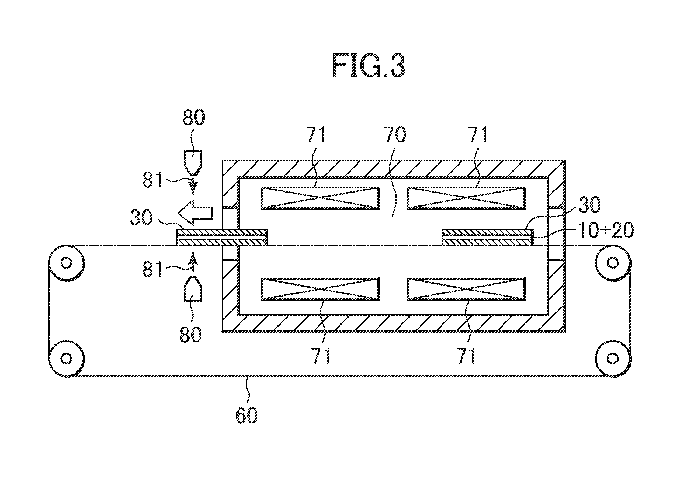

FIG. 3 shows a sectional view of a soldering step using the soldering method of the present invention.

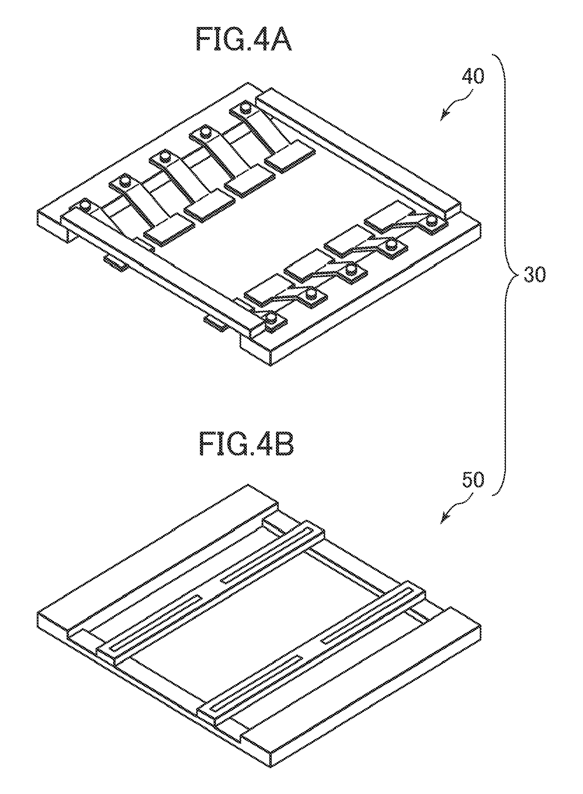

The soldering step involves the use of a transport holder 30 comprised of an upper holder 40 and a lower holder 50, one example of which is shown in FIGS. 4A and 4B. The transport holder 30 positions and holds the photovoltaic cell 10 and the interconnectors 20. When soldering a plurality of photovoltaic cells 10 and interconnectors 20 as shown in FIGS. 1 and 2, the required number of transport holders 30 is connected at constant intervals and used. For simplicity, a description is given of transporting only a single transport holder 30 to a heating space 70 using a transport conveyer 60.

In the soldering method of the present invention, the photovoltaic cell 10 and the interconnectors 20 are positioned and held using the photovoltaic cell transport holder 30, with soldering carried out using a transport conveyer 60 that conveys the transport holder 30, a heating space 70 and a cooling means 80. The heating space 70 is a chamber-like space disposed so as to straddle the transport conveyer 60 from above and below, and formed in such a way that a transport surface of the transport conveyer 60 runs through an interior of the heating space 70. A plurality of heating means 71 is positioned inside the heating space 70, and cooling means 80 are disposed above and below an exit of the heating space 70.

### Heating

The transport holder 30 transports the photovoltaic cell 10 to the heating space 70 with the transport conveyer 60, with the interconnectors 20 positioned and pressed against the electrodes 11 of the photovoltaic cell 10 and forming the attachment portions 12.

Inside the heating space 70, the plurality of heating means 71, such as a plurality of heaters, is disposed both above and below the transport conveyer 60 so as to sandwich the transport conveyer 60 therebetween. The photovoltaic cell 10, having been brought to the heating space 70 by the transport holder 30, is then heated on both top and bottom surfaces simultaneously by the heating means 71, melting the solder 22.

The heated photovoltaic cell 10 on the transport holder 30 is then transported away from the heating space 70 by the transport conveyer 60.

### Method of Cooling after Melting the Solder (First Embodiment)

A description is now given of cooling means used in cooling after heating the solder, in a first embodiment of the present invention.

The photovoltaic cell 10 on the transport holder 30 transported away from the heating space 70 by the transport conveyer 60 is cooled by the cooling means 80 disposed above and below the exit of the heating space 70, and the melted solder 22 on the interconnectors 20 starts to harden from the end of the photovoltaic cell 10 inward. The photovoltaic cell 10 thus transported on the transport holder 30 by the transport conveyer 60 is sequentially cooled by the cooling means 80 from the end. In the present embodiment, cold blasts 81 are used as the cooling means 80. Cold blasts 81 are blown out of supply ports 82 such as nozzles or the like provided at the exit of the heating space 70 as shown in FIG. 3. In this case, cold blasts 81 are blown not only from above but also from below.

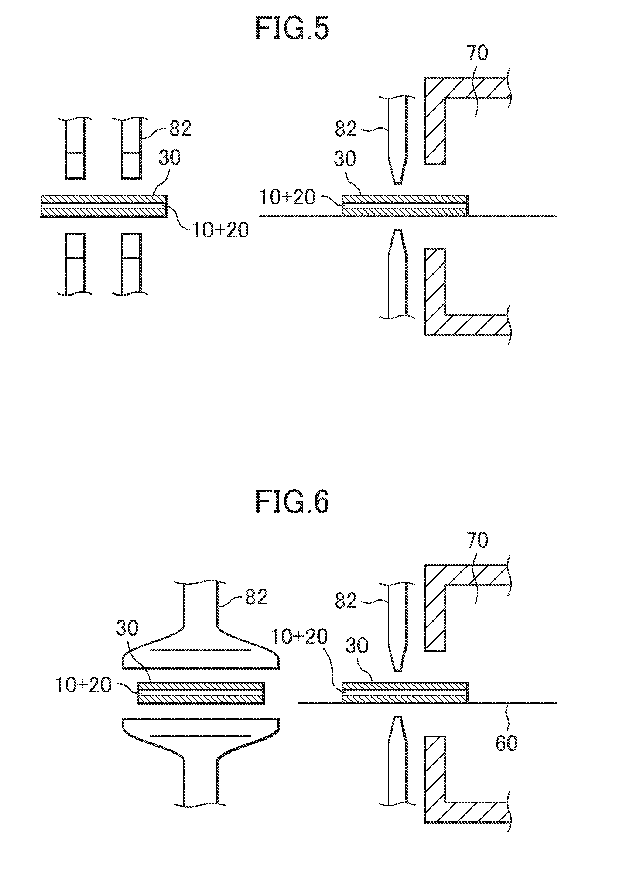

The supply ports 82 provided above and below the exit of the heating space 70, as one example as shown in FIG. 5, are aligned with the positions of the upper and lower interconnectors 20 that are to be soldered to the photovoltaic cell 10. The width of the tips of the supply ports 82 is reduced in a long direction of the interconnectors 20.

### Second Embodiment

A description is now given of the cooling means used in cooling after heating the solder, in a second embodiment of the present invention.

In the second embodiment, as shown in FIG. 6, the supply ports 82 provided above and below the exit of the heating space 70 extend across the entire width of the photovoltaic cell 10, and the width of the tip of the supply ports is reduced in the long direction of the interconnectors 20.

### Third Embodiment

A description is now given of cooling means used in cooling after heating the solder, in a third embodiment of the present invention.

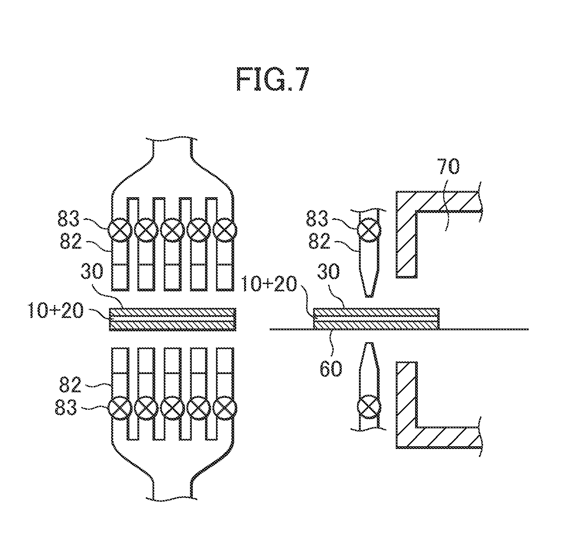

In the third embodiment, the supply ports 82 consist of a plurality of ports whose number and position may be varied according to a temperature distribution of the photovoltaic cell 10 as shown in FIG. 7. A flow adjustment valve 83 is provided on each one of the plurality of supply ports 82 to adjust the cold blast flow volume.

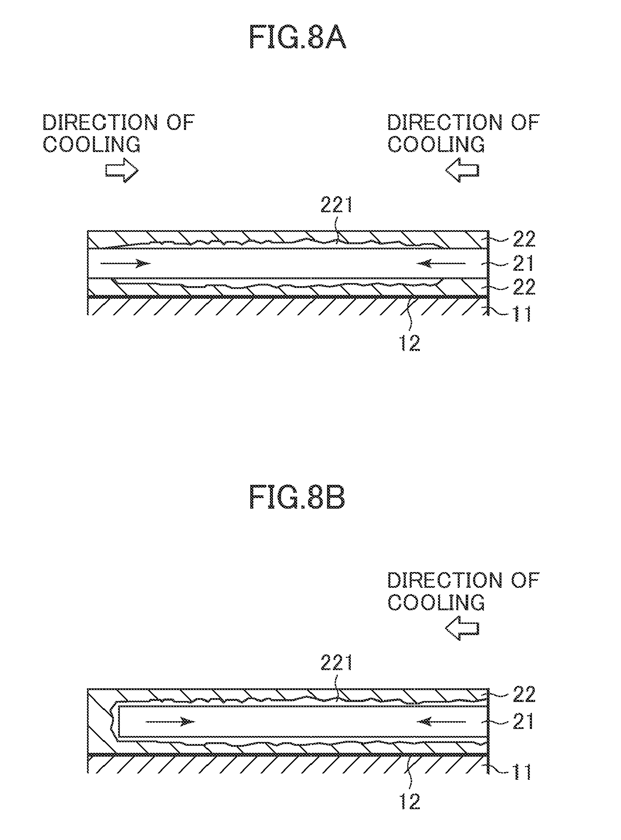

Using FIGS. 8A and 8B, a description is now given of how the interconnectors 20 on the photovoltaic cell 10 harden using the cooling means 80 described above.

FIGS. 8A and 8B show sectional views of the interconnector 20 during cooling, with FIG. 8A showing cooling conducted gradually under normal ambient conditions and FIG. 8B showing cooling sequentially from the end of the cell inward using the cooling means 80.

In FIG. 8A cooling is conducted gradually, and therefore the cooling of the interconnector 20 proceeds from both ends inward toward the center. In addition, since the cooling is gradual, the thermal contraction of the lead wire 21 and the hardening of the solder 22 take place simultaneously, unaffected by any difference in coefficient of thermal conductivity. As a result, the solder 22 hardens before the lead wire 21 undergoes adequate heat contraction, creating a compressive force on the interconnector that results in bending of the photovoltaic cell.

By contrast, when the cell is cooled sequentially inward from the end by the cooling means 80, as shown in FIG. 3, the photovoltaic cell 10 is cooled by the cooling means 80 while being transported by the transport conveyer 60.

Consequently, the interconnector 20 is cooled from the end in the long direction thereof (the end of the cell), along the long direction. As a result, as shown in FIG. 8B, when the lead wire 21 undergoes heat contraction, it moves and contracts within melted solder 221, and thus the heat contraction of the lead wire is not limited by the hardening of the solder 22 and the interconnector compressive force after cooling can be reduced.

In addition, as shown in FIG. 8B the interconnector 20 is cooled by cold blasts 81, and therefore the copper wire lead 21 with its higher coefficient of thermal conductivity, undergoes heat contraction before the solder 22 does. As a result, by the time the solder 22 has hardened the lead wire 21 has already undergone adequate heat contraction, and thus the interconnector compressive force after cooling can be reduced.

Thus, as described above, using the cooling means 80 enables bending of a square soldered cell having a length of 150 mm on a side and having a thickness of 150 µm to be held to within ± 2 mm.

### Fourth Embodiment

A description is now given of a fourth embodiment of a cooling means 80 that is even more effective at preventing bending of a photovoltaic cell after melting solder.

The fourth embodiment uses a cooling gas for the cold blasts 81 supplied to the photovoltaic cell by the cooling means 80. The shape of the supply ports 82 is the same as that of the first embodiment, although since a cooling gas is used the bottom supply ports shown in FIG. 3 can be eliminated.

For the cooling gas, chlorofluorocarbon, nitrogen, carbon dioxide, and inert gases can be used, either singly or in some combination thereof. The cooling gas is cooled to a temperature of approximately -40 degrees Centigrade and blown onto the surface of the cell. In view of environmental concerns it is preferable to use an alternative chlorofluorocarbon as the cooling gas.

In addition, since cooling can be conducted rapidly using cooling gas, the cell can be cooled in less time than in the first through third embodiments, and as described in FIG. 8A and FIG. 8B, cooling sequentially from end of the cell inward enables the anti-bending effect to be enhanced.

As many apparently widely different embodiments of the present invention can be made without departing from the spirit and scope thereof, it is to be understood that the invention is not limited to the specific embodiments thereof except as defined in the appended claims.

## Claims

1. A method for soldering an interconnector to a photovoltaic cell, comprising:
positioning the interconnector at a predetermined position on the photovoltaic cell;
holding the interconnector and the photovoltaic cell tightly together;
melting the solder while heating the photovoltaic cell;
sequentially cooling the heated photovoltaic cell in a long direction of the interconnector with cold blasts from end of the photovoltaic cell in a long direction of the interconnector.

2. The method for soldering an interconnector to a photovoltaic cell according to claim 1, wherein the cold blasts with which the photovoltaic cell is cooled are supplied across an entire width of the photovoltaic cell in a direction at a right angle to the interconnector soldered to the photovoltaic cell, and are supplied locally in the long direction of the interconnector.

3. The method for soldering an interconnector to a photovoltaic cell according to claim 1, wherein the cold blasts with which the photovoltaic cell is cooled are supplied for one or more nozzles.

4. The method for soldering an interconnector to a photovoltaic cell according to claim 1, wherein the cold blasts with which the photovoltaic cell is cooled are a cooling gas comprising any one of chlorofluorocarbon, nitrogen, carbon dioxide, and inert gases, or any combination thereof.

5. An apparatus for cooling a photovoltaic cell to which an interconnector is soldered, comprising:
a heating space to melt the solder while heating the photovoltaic cell to attach the interconnector to the cell;
a transport conveyer to transport the photovoltaic cell to and from the heating space; and
a plurality of supply ports, at least one supply port of the plurality of supply ports disposed above an exit of the heating space and at least one other supply port of the plurality of supply ports disposed below the exit of the heating space,
a plurality of supply ports sandwiching the photovoltaic cell on the transport conveyer therebetween to blow cold blasts to sequentially cool the heated photovoltaic cell in a long direction of the interconnector from end of the photovoltaic cell in a long direction of the interconnector,
a tip portion of each supply port of the plurality of supply ports having a tapered section of reduced width in the long direction of the interconnector proximal to the transport conveyer.

6. The apparatus according to claim 5, wherein a tip portion of each supply port of the plurality of supply ports has a flared section of expanded width at a right angle to the long direction of the interconnector of the photovoltaic cell.

7. The apparatus according to claim 5, further comprising a plurality of flow adjustment valves provided on the plurality of supply ports to adjust a flow of the cold blasts from the supply ports,
wherein each supply port is provided with one flow adjustment valve.
